Europäisches Patentamt

(19) European Patent Office

Office européen des brevets

(11) EP 0 766 404 A2

(12) **EUROPEAN PATENT APPLICATION**

(43) Date of publication:
02.04.1997 Bulletin 1997/14

(51) Int. Cl.⁶: H03L 7/18

(21) Application number: 96112718.0

(22) Date of filing: 07.08.1996

(84) Designated Contracting States:
DE GB NL

(30) Priority: 28.09.1995 JP 250631/95

(71) Applicant: NEC CORPORATION
Tokyo (JP)

(72) Inventor: Katsuta, Hiroshi,
c/o NEC Corp.
Tokyo (JP)

(74) Representative: Baronetzky, Klaus, Dipl.-Ing. et al
Patentanwälte
Dipl.-Ing. R. Splanemann, Dr. B. Reitzner, Dipl.-
Ing. K. Baronetzky
Tal 13
80331 München (DE)

(54) **Clock generator utilizing phase locked loop circuit**

(57) A clock generator is disclosed which utilizes a
PLL circuit composed of a phase comparator 2, a low
pass filter 3, a voltage controlled oscillator (VCO) 4 and
a first frequency divider 5 to make the VCO oscillate in
a relationship with a reference (input) clock signal.
There is further provided a second frequency divider 12
outside the loop of the PLL circuit, the divider respond-
ing to the output of the VCO to produce a clock signal
having a variable frequency.

Fig. 2

**Description**

BACKGROUND OF THE INVENTION

The present invention relates to a clock generator for generating and supplying a clock signal to a data processing unit such as a control processing unit (CPU) and, more particularly, to such a clock generator that utilizes a phase locked loop (PLL) circuit to generating a clock signal having a desired clock rate or frequency.

In order to make it possible for a data processing apparatus such as a microcomputer or a microprocessor to enhance a data processing operation speed and/or efficiency, it is necessary to make a rate or frequency of a system clock signal supplied thereto. On the other hand, the system clock signal is required to be accurate in frequency. For this purpose, it is ordinal to use a crystal clock generator. However, such a crystal that have a very high resonant frequency is very expensive to make a system costly.

It has been therefore proposed and put into practical use to utilized a PLL circuit to produce a system clock signal. With this construction, it is available to a high frequency clock signal based upon a low frequency clock signal from a crystal oscillator.

The clock generator is further required to change the frequency of the system clock signal. In a standby mode, for example, the system clock signal is lowered in frequency to thereby reduce power consumption.

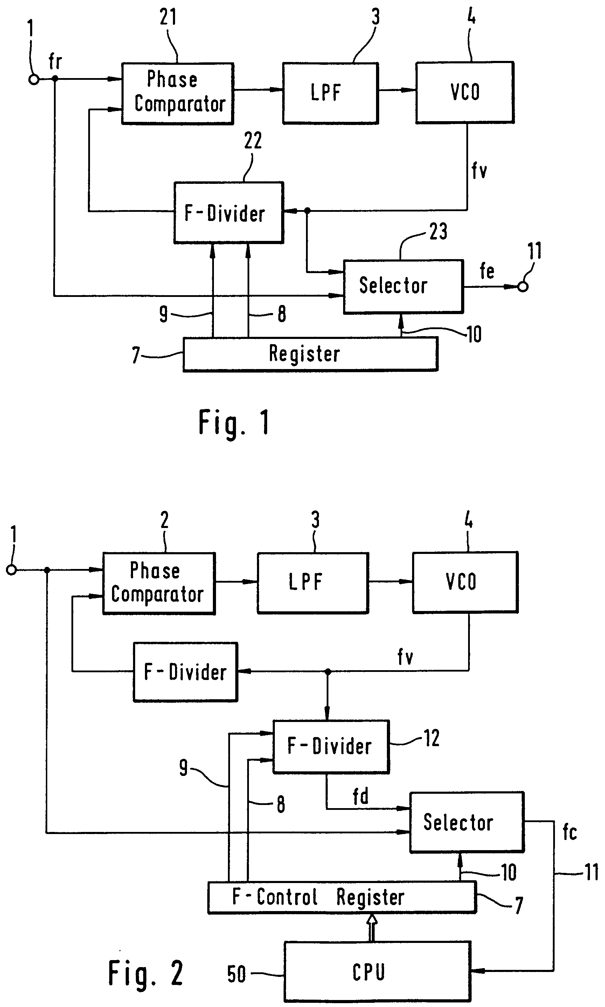

For the purposes described above, Japanese Patent Laid-Open Publucation Hei 4-12842 presents a certain clock generator, which is shown in Fig. 1.

This clock generator includes a clock input terminal 1 supplied with a clock signal from a crystal oscillator (not shown). The terminal 1 is in turn connected as a reference clock input to one input node of a phase detector 21 of a PLL circuit 20. The output of the phase detector 21 is connected to a low-pass filter 3 which responds thereto and produces a control voltage to control the oscillation frequency of a voltage-controlled oscillator (VCO) 4. The output of the voltage control oscillator 4 is supplied to a modulo divider 22. The divider 22 frequency-divides the output of the VCO 4 and supplies the other input node of the phase detector 21 with the divided signal.

The frequency-division ratio of the divider is controlled or changed by control signals 8 and 9 outputted from a frequency control register 7. This register 7 further outputs a clock selector signal 10 to a selector 23 which receives the signals from the terminal 1 and the VCO 4. In response to the information of the signal 10, the selector 23 selects and outputs one of the signals of the terminal 1 and the VCO 4 at an output terminal 11. The clock signal derived from the terminal 11 is supplied to a CPU (not shown) as a system clock signal.

As is well known in the art, assuming that the frequency of the signal at the terminal 1 is fr and the division ratio of the modulo divider 22 is m, the PLL circuit 20 operates to have the VCO 4 generates the clock signal having the following frequency fv:

$$fv = m \times fr.$$

The timing selector 23 selects either the input clock signal (fr) and the output (fv) of the VCO 4 as a CPU clock fe in accordance with the level of the clock selector signal 10. That is, fe = fr or fv.

For example, supposing that 5 MHz is supplied as the input clock signal fr and the frequency-division ratio of the modulo divider 22 is determined by the control signal 8 to be 2, the VCO output becomes 10 MHz is frequency. In the case of the division ratio being 5 by the control signal 9, the VCO output becomes 25 MHz in frequency. As a result, the CPU clock takes 5 MHz, 10 MHz or 25 MHz in accordance with the contents of the control signals 8 - 10.

Thus, the above clock generator can generate such a clock signal that is higher in requency than the input clock signal and further can control the frequence of an actual system or CPU clock signal.

In the above clock generator, however, it is required to change the frequency division ratio of the modulo divider 22 in order to vary the VCO frequency. In this case, the so-called lock-up time is needed for the PLL 20 to be stable and to oscillate at a desired frequency. This lock-up time is caused by bandwidth characteristics of the loop, namely, bandwidth characteristics of the low-pass filter 3. When the bandwidth is wide, the lock-up time is shortened but the jitter is made greater, so a CPU clock fc which is stable in frequency and duty cannot be obtained. In order to obtain a stable CPU clock fc, therefore, it is necessary to make more narrow the bandwidth of the low-pass filter 3 and make higher the sensitivity, but in this case there is a problem that the locking time is made longer.

In case where fe is switched from 5 MHz to 25 MHz, the lock-up time of about 10 microseconds is needed. This is equivalent to 250 clock pulses in number of clock pulses of 25 MHz. Since this time is equivalent to the execution time of 250 instructions in a RISC-type processor which executes each instruction in one clock. For this reason, the processor employing the above clock generator is inferior in program execution efficiency.

SUMMARY OF THE INVENTION

It is therefore an object of the invention to provide an improved clock generator utilizing a PLL circuit.

It is another object of the present invention to provide a clock generator which can be change the frequency of a clock signal immediately.

A clock generator according to the present invention utilized a PLL circuit to generate a first clock signal relative to an input clock signal and further includes a frequency divider which is provided outside the loop of the PLL circuit to receive the first clock signal. The frequency-division ratio of the divider is controlled by a set of control signals to produce an output clock signal having a variable or controllable frequency.

With the above construction, since the frequency divider is outside the PLL loop, the change in frequency-division ratio of the divider gives no effect to the PLL loop. That is, the PLL circuit is in a stable state irrespective of whether or not the divider is changed in frequency-division ratio. Accordingly, the output clock is changed in frequency without requiring the lock-up time of the PLL circuit.

BRIEF DESCRIPTION OF THE DRAWINGS

The above and other objects, features and advantages of the present invention will be more apparent from the following description taken in conjunction with the accompanying drawings, in which:

Fig. 1 is a block diagram illustrative of a clock generator according to the prior art;
Fig. 2 is a block diagram illustrative of a clock generator according to an embodiment of the present invention;
Fig. 3 is a circuit diagram representative of a frequency divider 12 shown in Fig. 2; and
Fig. 4 is a timing chart representative of an operation of a clock generator shown in Fig. 2.

DETAILED DESCRIPTION OF THE EMBODIMENT

Referring now to Fig. 2, a clock generator according to an embodiment of the present invention utilizes a PLL circuit 20. This circuit 20 includes an input terminal 1 supplied with an input clock signal from a quartz-crystal oscillator or an external system (both not shown) as a reference clock, that terminal 1 being connected to one input side of a phase and/or frequency comparator 2. The output of the comparator 2 is supplied to a low-pass filter 3 whose output signal is in turn supplied a voltage controlled oscillator (VCO) 4 to control the oscillation frequency thereof. The signal from the VCO 4 is supplied to and thus frequency-divided by a frequency divider 5. The frequency-divided output of the divider 5 is fed back to the other input side of the phase comparator 2. Thus, the PLL circuit 20 is constituted, and the frequency fv of the output signal of the VCO 4 is represented as follows:

$$fv = M \times fr,$$

wherein fr is a frequency of the input clock signal and M is a frequency division ratio of the divider 5.

The output signal of the VCO 4 is further supplied to a frequency divider 12 which is provided in accordance with the present invention. This divider 12 can take in the present embodiment two frequency-division ratio in accordance with the contents of control signals 8 and 9 which are supplied from a frequency control register 7.

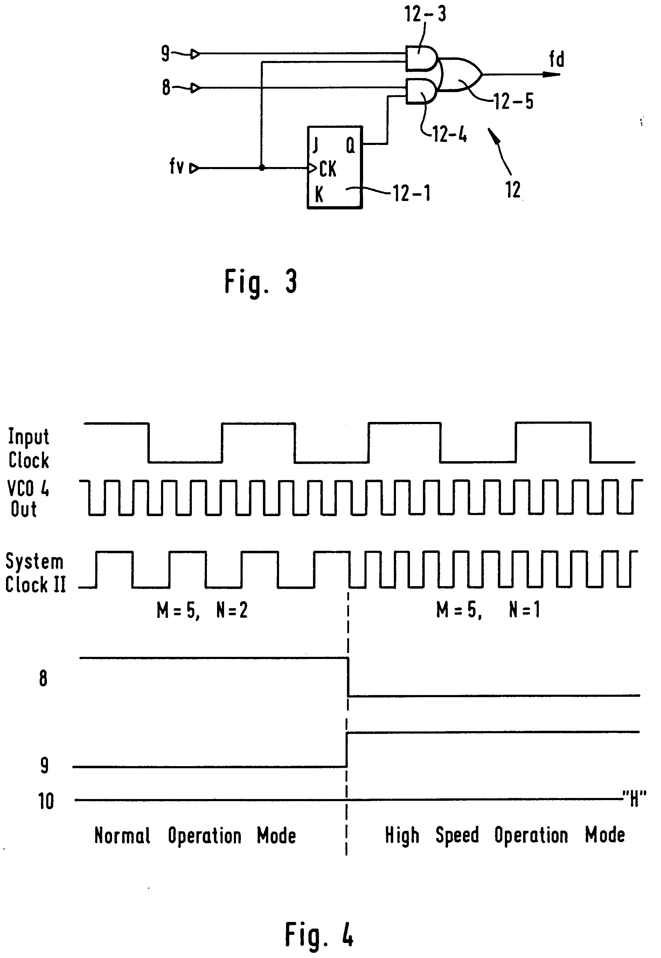

Referring to Fig. 3, the divide 12 includes a J-K flip-flops 12-1, two AND gates 12-3 and 12-4 and an OR gate 12-5, which are connected as shown. Accordingly, when the control signals 8 and 9 takes "0" and "1", respectively, the frequency-division ratio N of the divider 12 becomes 1. In the case of the signals 8 and 9 takes respectively "1" and "0", the divider 12 takes the division ratio N of 2.

Turning back to Fig. 2, the output signal of the divider 12 is supplied to a clock selector 6 together with the input clock signal. The clock selector 6 selects the output of the divider 12 when the control signal 10 assumes the high level and the input clock signal when the control signal 10 assumes the low level. The control signal 10 is also supplied from the register 10.

The clock signal thus selected by the selector 6 is supplied to a CPU 50 as a system or CPU clock signal 11. The CPU 50 operates based upon the clock signal 11 to execute each instruction and process data. Further, the CPU 50 controls the register 7 to change the contents thereof.

In the above clock generator, supposing that the input clock is 5 MHz in frequency and the ratio of the frequency divider 5 is 5, fv = 25 MHz is obtained. In this state, when only the control signal 8 assumes "1", the divider 12 produces its output of a frequency of 12.5 MHz is obtained. On the other hand, fd becomes 2 25 MHz when only the signal 9 assumes "1".

As described above, since the system clock signal 11 can take three kinds of frequency, the CPU 50 is operable in three modes. These three modes consist of a normal operation mode, a high speed operation mode and a standby mode.

In the normal operation mode, the control signals 8, 9 and 10 takes "1", "0" and "1", respectively, as shown in Fig 4. The frequency-division ratio N of the divider 12 thereby becomes 2 and the clock selector 6 selects and outputs the signal from the divider 12 as the system clock signal 11. This signal has a frequency fc of 12.5 MHz. The CPU 50 operates based upon this system clock 11.

When an external event happens at this time, which even requires the CPU 50 of performing a data operation at a high speed, the CPU 50 rewrites the frequency control register 7 such that the control set so that the signals 8, 9 and 10 takes "0", "1" and "1", respectively, as shown in Fig. 2. As a result, the division ratio N of the divider 12 is switched to 1. The output of the divider 12 is thereby immediately switched to 25 MHz and the system clock 11 is also changed to 25 MHz in an instant. The CPU 11 operates on the system clock signal of 25 MHz as the high speed operation mode.

In the standby mode, the CPU 11 changes the signal 10 to the low level, so that the system clock signal 11 is changed to be 5 MHz. Power consumption is thereby reduced.

In this embodiment, the frequency divider 12 is switched between two states but it is possible to obtain various clocks lower than a frequency outputted from the VCO 4 by setting three or more division ratios into the divider 12. That is, the present invention is not limited to the above embodiment, but may be changed and modified without departing the scope and spirit of the invention.

## Claims

1. A clock generator comprising a phase locked loop circuit responding to a reference clock signal and producing a first clock signal, a frequency divider provided outside said phase locked loop circuit to receive said first clock signal, said frequency divider operating in a first mode to produce a second clock signal and in a second mode to produce a third clock signal which is different in frequency from said second clock signal, a clock output terminal, and means for transferring an output of said frequency divider to said clock output terminal.

2. The generator as claimed in claim 1, wherein each of said first to third clock signals is higher in frequency than said reference clock signal.

3. The generator as claimed in claim 2, wherein said means comprises a clock selector supplied with said reference clock signal and the output of said frequency divider and selecting and outputting one of said reference clock signal and the output of said frequency divider to said clock output terminal in response to a control signal supplied thereto.

4. A clock generator comprising: a phase locked loop circuit including an oscillator oscillating to produce a first clock signal, a first divider frequency-dividing the oscillation signal of said oscillator to produce a second clock signal, and a phase detector responding to said second clock signal and a reference clock signal to control an oscillation of said oscillator; a second divider coupled to receive said first clock signal and producing a third clock signal having a variable frequency; and means for producing an output clock signal in response to said third clock signal.

5. The generator as claimed in claim 4, wherein said second divider frequency-divided said second clock signal at a first frequency division ratio when first control information supplied thereto assumes a first state and at a second frequency division ratio when said first control information assumes a second state.

6. The generator as claimed in claim 5, wherein said means comprises a clock selector selects and outputs said reference clock signal as said output clock signal when second control information assumes a third state and selects and outputs said third clock signal as said output clock signal when said second control in formation assumes a fourth state.

Fig. 1

Fig. 2

EP 0 766 404 A2

Fig. 3

Fig. 4